# FASCICULE DE BREVET EUROPEEN

(11) **EP 2 944 970 B1**
(45) Date de publication et mention de la délivrance du brevet: **14.12.2016**
(21) Numéro de dépôt: 15158714.4
(22) Date de dépôt: 11.03.2015
(51) Int. Cl.: G01R 31/36

(54) **Procédé d'estimation de l'état de santé d'une cellule de batterie**
Verfahren zur Abschätzung des Gesundheitszustands einer Batteriezelle
Method for estimating the state of health of a battery cell

(30) Priorité: 17.03.2014 FR 1452182
(43) Date de publication de la demande: 18.11.2015
(73) Titulaire: COMMISSARIAT A L'ENERGIE ATOMIQUE ET AUX ENERGIES ALTERNATIVES, 75015 Paris (FR); DECATHLON, 59650 Villeneuve d'Ascq (FR)
(72) Inventeur: Vinit, Laurent, 73370 LE BOURGET DU LAC (FR); Karoui, Fathia, 73000 Chambery (FR)
(74) Mandataire: Thibon, Laurent

(56) Documents cités:
- EP-A2- 1 263 111
- JP-A- 2000 261 901
- US-A1- 2013 090 872

## Description

### Domaine

La présente demande concerne le domaine des batteries électriques de façon générale, et vise plus particulièrement la détermination de l'état de santé ou état de vieillissement d'une cellule élémentaire d'une batterie.

### Exposé de l'art antérieur

Une batterie électrique est un groupement de plusieurs cellules élémentaires rechargeables (piles, accumulateurs, etc.) reliées en série et/ou en parallèle entre deux noeuds ou bornes de fourniture de tension.

Une batterie est souvent associée à un dispositif de gestion relié aux cellules de la batterie, qui peut mettre en oeuvre des fonctions diverses telles que des fonctions d'équilibrage des cellules, des fonctions de protection, etc.

Dans certains systèmes, le dispositif de gestion gère des jauges ou indicateurs lui permettant de connaître à tout instant l'état de charge, aussi appelé SOC (de l'anglais "State of Charge") de chaque cellule élémentaire de la batterie, c'est-à-dire le rapport entre la charge contenue dans la cellule et la capacité totale de la cellule à l'instant considéré. Le dispositif de gestion peut par exemple estimer l'état de charge de chaque cellule à partir d'algorithmes prédéfinis et/ou de mesures réalisées par des capteurs reliés aux cellules de la batterie.

Dans certains systèmes, le dispositif de gestion gère en outre un indicateur complémentaire représentatif du vieillissement des cellules, généralement appelé SOH, de l'anglais "State of Health" pour état de santé. A un instant donné de la vie d'une cellule, le SOH est égal au rapport de la capacité de la cellule à l'instant considéré sur la capacité de la cellule à l'état neuf. La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules, de façon à leur permettre de continuer à fournir une estimation relativement fiable.

Les techniques connues de détermination du SOH d'une cellule passent par la mesure de la capacité de cette cellule. Pour cela, la cellule peut être complètement déchargée puis complètement rechargée, ou complètement rechargée puis complètement déchargée. Lors de la phase de recharge complète ou de décharge complète, la charge accumulée dans la cellule ou extraite de la cellule peut être mesurée par comptage coulométrique, ce qui revient à mesurer la capacité réelle de la cellule. Connaissant la capacité réelle de la cellule, le dispositif de gestion peut ensuite calculer le SOH de la cellule en divisant cette capacité réelle par la capacité de la cellule à l'état neuf ou par la capacité nominale de la cellule, qui peut être mémorisée dans le dispositif de gestion. Un inconvénient de ces techniques de détermination du SOH est qu'elles nécessitent la mise en oeuvre d'une décharge complète de la cellule suivie d'une charge complète, ou d'une charge complète suivie d'une décharge complète, ce qui est relativement contraignant et peut poser problème dans certaines applications.

Le document JP2000261901 décrit une méthode de mesure de la dégradation de la capacité d'une batterie.

### Résumé

Ainsi, un mode de réalisation selon la revendication 1 prévoit un procédé de détermination de l'état de santé d'une première cellule élémentaire d'une batterie, comprenant les étapes suivantes : mesurer la tension aux bornes de la cellule sous un courant de référence à plusieurs instants d'une phase de charge ou de décharge de la cellule entre des premier et second niveaux d'état de charge ; et détecter un passage de la tension par une valeur particulière prédéterminée, correspondant à une valeur particulière prédéterminée de charge de la cellule, les valeurs particulières de charge et de tension correspondant aux coordonnées d'un point de croisement d'au moins deux courbes représentatives de l'évolution de ladite tension en fonction de la charge contenue dans la cellule, à des états de vieillissement distincts de la cellule.

Selon un mode de réalisation, le procédé comporte en outre la détermination et la mémorisation de variations de charge de la cellule entre les mesures de tension.

Selon un mode de réalisation, les variations de charge sont mesurées par un compteur de coulombs ou un intégrateur de courant.

Selon un mode de réalisation, les variations de charge sont estimées en tenant compte du temps écoulé entre les mesures de tension.

Selon un mode de réalisation, le procédé comporte une étape de détermination de la pente de la courbe représentative de l'évolution de la tension en fonction de la variation de charge de la cellule, au passage par la valeur particulière de tension.

Selon un mode de réalisation, le procédé comporte une étape de calcul de la valeur moyenne de la tension entre des premier et second niveaux de charge de la cellule, les premier et second niveaux de charge étant tous deux supérieurs à la valeur particulière de charge ou tous deux inférieurs à la valeur particulière de charge.

Selon un mode de réalisation, le procédé comprend en outre, après la détection du passage de la tension par la valeur particulière prédéterminée, une étape de recharge complète de la cellule, et la mesure de la charge injectée dans la cellule pendant cette étape de recharge.

Selon un mode de réalisation, la valeur particulière de charge est comprise entre 20% et 60% de la capacité nominale de pleine charge de la cellule.

Selon un mode de réalisation, la cellule est une cellule de type lithium-ion, et la valeur particulière de charge est comprise entre 38% et 42% de la capacité nominale de pleine charge de la cellule.

Selon un mode de réalisation, la cellule présente une capacité nominale de 2,2 Ah et une tension nominale de pleine charge de 4,2 V, et la valeur particulière de tension est comprise dans la plage allant de 3,5 V à 3,6 V.

Selon un mode de réalisation, le procédé comporte en outre une phase préalable de caractérisation comportant l'acquisition, pour une deuxième cellule élémentaire de même type que la première cellule, d'au moins deux courbes caractéristiques représentatives de l'évolution de la tension aux bornes de la deuxième cellule en fonction de la charge contenue dans la deuxième cellule, à au moins deux états de vieillissement distincts de la deuxième cellule.

Selon un mode de réalisation, la phase préalable de caractérisation comprend en outre une étape de détermination d'un point de croisement des deux courbes caractéristiques dans la plage de charge allant de 20% à 60% de la capacité nominale de la cellule.

Un autre mode de réalisation prévoit un système comportant : une batterie comportant plusieurs cellules élémentaires et un dispositif de gestion de la batterie, dans lequel le dispositif de gestion est adapté à déterminer l'état de santé d'une cellule élémentaire par un procédé du type susmentionné.

Selon un mode de réalisation, la batterie est une batterie à architecture reconfigurable dynamiquement, et le dispositif de gestion est adapté à déconnecter et reconnecter dynamiquement des cellules de la batterie de façon que la batterie fournisse à ses bornes une tension alternative.

Selon un mode de réalisation, le courant de référence est nul, et les étapes de mesure de la tension aux bornes de la première cellule sont mises en oeuvre pendant des périodes de déconnexion de la première cellule par le dispositif de gestion en vue de la génération d'une tension alternative aux bornes de la batterie.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un diagramme illustrant l'évolution avec le vieillissement du comportement d'une cellule élémentaire de batterie ;
la figure 2 est un diagramme illustrant l'évolution avec le vieillissement d'une valeur caractéristique d'une cellule élémentaire de batterie ; et
la figure 3 illustre, sous forme de blocs, un exemple d'un mode de réalisation d'un procédé de détermination de l'état de santé d'une cellule élémentaire de batterie.

### Description détaillée

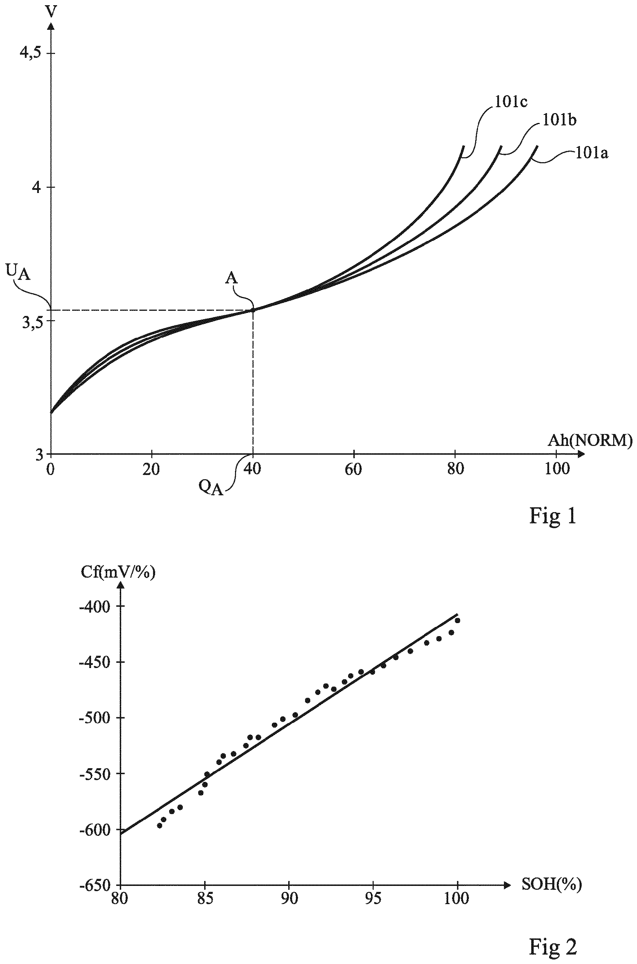

La figure 1 est un diagramme comportant trois courbes 101a, 101b et 101c représentant, pour trois états de vieillissement ou états de santé distincts d'une cellule élémentaire d'une batterie, l'évolution de la tension, en volts (V), aux bornes de la cellule sous un courant de référence i_{ref} (c'est-à-dire la tension aux bornes de la cellule lorsque la cellule est traversée par le courant i_{ref}), en fonction de la charge contenue dans la cellule. Les courbes de la figure 1 ont été tracées pour une cellule lithium-ion de type NMC (nickel cobalt manganèse)/graphite, présentant une capacité nominale, c'est-à-dire affichée par le fabricant, de 2,2 Ah, et une tension nominale de pleine charge de 4,2 V. La courbe 101a représente le comportement de la cellule à l'état neuf, la courbe 101b correspond à la même cellule après environ 600 cycles de charge/décharge représentatifs d'une utilisation typique de la cellule, et la courbe 101c correspond à la même cellule après environ 1200 cycles de charge/décharge représentatifs d'une utilisation typique de la cellule. Dans cet exemple, les mesures de tension ont été effectuées sous un courant de référence i_{ref} nul. De plus, sur la figure 1, la charge de la cellule, en abscisse, a été représentée en ampère-heure restants normalisés (Ah NORM), c'est-à-dire en pourcentage de la capacité nominale de la cellule. Il s'agit donc bien d'une grandeur représentative de la charge physique effectivement contenue dans la cellule, ou nombre d'Ah restants, et non pas de l'état de charge (SOC) de la cellule, qui, lui, est un pourcentage de la capacité totale réelle de la cellule qui peut varier avec le vieillissement de la cellule.

Les essais menés par les inventeurs ont montré que les courbes caractéristiques de la tension aux bornes de la cellule, sous un courant de référence constant, en fonction de la charge de la cellule, aux différents états de vieillissement de la cellule, sont toutes monotones (c'est-à-dire continument croissantes ou décroissantes) dans la plage d'utilisation de la cellule, et se croisent toutes en un même point caractéristique de la cellule, désigné ici par la référence A. Dans l'exemple particulier de la figure 1, le point A correspond à une tension U_{A} de 3,55 V et une charge Q_{A} de 40% de la capacité nominale de la cellule (soit 0,88 Ah dans cet exemple).

Les essais réalisés par les inventeurs ont en outre montré qu'un comportement similaire est observable lorsque les mesures de tension sont effectuées sous un courant de référence i_{ref} non nul, par exemple un courant négatif - c'est-à-dire un courant de décharge de la cellule - ou un courant positif - c'est-à-dire un courant de charge de la cellule. Dans ce cas, les coordonnées U_{A} et Q_{A} du point A peuvent changer par rapport à l'exemple de la figure 1, mais le même phénomène que dans l'exemple de la figure 1 se produit, c'est-à-dire que toutes les courbes caractéristiques tension/charge à des états de vieillissement distincts de la cellule se croisent en un même point A.

Les inventeurs ont en outre constaté que ce même phénomène est observable pour d'autres types de cellules que les cellules lithium-ion de l'exemple de la figure 1, par exemple des cellules lithium-ion présentant une capacité nominale différente de 2,2 Ah et/ou une tension nominale de pleine charge différente de 4,2 V, ou des cellules présentant une chimie différente, à condition que ces cellules présentent des caractéristiques tension/charge monotones (sans plateau), par exemple des cellules lithium ion de type LMO (LiMn₂O₄)/graphite. La position du point A dépend alors des caractéristiques de la cellule et du courant de référence i_{ref} considéré, et se trouve typiquement dans la plage de niveaux de charge allant de 20% à 60% de la capacité nominale de la cellule.

Pour un type de cellule donné, une phase de caractérisation peut être mise en oeuvre, permettant de déterminer la position du point A pour un courant de référence i_{ref} que l'on choisit, par exemple i_{ref} = 0 A. Un exemple non limitatif de procédé de caractérisation d'un type de cellule va maintenant être décrit.

Dans un premier temps, une cellule du type à caractériser, présentant un premier état de vieillissement, peut être complètement déchargée. Cette cellule peut ensuite être rechargée complètement en mesurant périodiquement pendant la charge la tension de la cellule sous le courant i_{ref}. La charge physique réelle contenue dans la cellule peut être mesurée pendant la phase de charge, par exemple à l'aide d'un compteur coulométrique ou d'un intégrateur de courant. On peut ainsi faire correspondre à chaque valeur de tension mesurée une valeur mesurée de charge contenue dans la cellule, de façon à obtenir une courbe caractéristique tension/charge restante du type représenté en figure 1. On notera que si le courant de charge est différent de i_{ref} (notamment dans le cas i_{ref}=0), on peut périodiquement forcer le courant traversant la cellule à la valeur i_{ref} pendant une courte durée, par exemple inférieure à 1 ms et de préférence inférieure à 10 µs, le temps d'effectuer une mesure de la tension aux bornes de la cellule. Alternativement, la courbe caractéristique tension/charge peut être acquise pendant une phase de décharge complète de la cellule, plutôt que pendant une phase de charge.

La cellule peut ensuite être "vieillie" en étant soumise à des cycles de charge/décharge représentatifs d'une utilisation typique de la cellule.

Les étapes susmentionnées peuvent être répétées au moins une fois pour obtenir au moins une deuxième courbe caractéristique tension/charge du type représenté en figure 1, à au moins un deuxième état de vieillissement de la cellule.

Lorsqu'au moins deux courbes caractéristiques tension/charge correspondant à des états de vieillissement distincts de la cellule ont été enregistrées, le point A peut être déterminé à partir de ces courbes, par exemple en recherchant le point de croisement entre ces deux courbes caractéristiques dans la plage de charge allant de 20% à 60% de la capacité nominale de la cellule.

Les mesures de tension en fonction de la charge effectuées lors de la phase de caractérisation peuvent optionnellement être lissées avant la détermination du point A. A titre d'exemple numérique non limitatif, des points des courbes caractéristiques tension/charge peuvent être acquis à une fréquence de 100 kHz (un point toutes les 10 µs), puis moyennés sur une fenêtre glissante de 2000 points (20 ms).

Une fois les coordonnées du point A connues pour un type de cellule et un courant de référence i_{ref}, elles peuvent être mémorisées par un dispositif de gestion d'une batterie comportant des cellules élémentaires de ce type.

La détection, par le dispositif de gestion, du passage d'une cellule de la batterie au point A lorsque la batterie est en cours d'utilisation, permet au dispositif de gestion de connaître de façon fiable la charge disponible dans cette cellule, indépendamment d'éventuelles dérives des jauges de la batterie liées au vieillissement des cellules ou à d'autres phénomènes.

Le dispositif de gestion de la batterie est par exemple adapté à mettre en oeuvre, pour chaque cellule de la batterie, un procédé de détection d'un passage au point A comportant les étapes suivantes :
mesurer la tension aux bornes de la cellule sous le courant de référence i_{ref} à plusieurs instants d'une phase de charge ou de décharge de la cellule entre des premier et second niveaux d'état de charge de la cellule, par exemple entre 20% et 80% du SOC de la cellule ; et
détecter une valeur particulière prédéfinie U_{A} de cette tension, mémorisée dans le dispositif de gestion, cette tension correspondant à la coordonnée en tension du point A prédéterminée lors de la phase de caractérisation.

La phase de charge ou de décharge du procédé de détection du point A peut correspondre à une charge ou une décharge de la cellule par utilisation normale de la batterie par un système comportant la batterie, par exemple un véhicule à assistance électrique. Si le courant de charge ou de décharge normal de la cellule est différent du courant de référence i_{ref}, le dispositif de gestion peut périodiquement forcer le courant traversant la cellule à la valeur i_{ref} pendant une durée de préférence suffisamment courte pour ne pas gêner le fonctionnement du système, par exemple pendant une durée inférieure à 1 ms et de préférence inférieure à 10 µs, le temps d'effectuer une mesure de la tension aux bornes de la cellule. Cette durée est de préférence choisie, le cas échéant, identique ou similaire, par exemple égale à 20% près, à la durée pendant laquelle le courant est périodiquement forcé à la valeur i_{ref} pendant la phase de caractérisation pour acquérir des courbes caractéristiques de la cellule. A titre de variante, le procédé de détection du point A peut comprendre une phase dédiée de charge ou de décharge de la cellule, qui peut être mise en oeuvre par le dispositif de gestion de la batterie spécifiquement pour provoquer un passage de la cellule par le point A et permettre ainsi la détection du passage au point A.

Le procédé susmentionné de détection du passage au point A d'une cellule d'une batterie peut par exemple être utilisé par le dispositif de gestion en vue de recaler ou réajuster une jauge d'état de charge de la cellule. Le dispositif de gestion de la batterie peut par exemple mettre en oeuvre un procédé d'évaluation de l'état de charge d'une cellule de la batterie, ce procédé comportant des phases d'estimation de l'état de charge de la cellule, et, entre des phases d'estimation, des phases de recalage du procédé d'estimation permettant de compenser d'éventuelles dérives, par exemple des dérives liées au vieillissement de la cellule ou des dérives des mesures effectuées par des capteurs du système de gestion, ces phases de recalage pouvant comprendre des phases de détection du passage au point A de la cellule. A titre d'exemple, une jauge d'état de charge de la cellule peut être recalée suite à une phase de détection d'un passage au point A de la cellule, pour compenser un éventuel écart entre une valeur de charge estimée de la cellule et la valeur de charge réelle connue au point A, à l'instant de détection du point A. Un avantage est que le recalage d'une jauge d'état de charge de la cellule par détection d'un passage au point A de la cellule ne nécessite pas une décharge complète ou une charge complète de la cellule. Ceci permet de rendre les phases de recalage nettement moins contraignantes qu'avec les solutions connues de recalage de jauge d'état de charge. On peut notamment prévoir des recalages plus fréquents que dans les systèmes existants. Ceci peut par exemple permettre d'utiliser des algorithmes d'estimation d'état de charge plus simples que dans les systèmes existants, puisqu'une éventuelle diminution de la fiabilité des algorithmes d'estimation peut être compensée par des recalages plus fréquents.

Selon un aspect des modes de réalisation décrits, une détection, par le dispositif de gestion, du passage d'une cellule de la batterie au point A, peut être utilisée pour déterminer l'état de santé ou SOH de la cellule.

Un exemple de procédé de détermination du SOH d'une cellule d'une batterie, pouvant être mis en oeuvre par un dispositif de gestion de la batterie, va maintenant être décrit.

Ce procédé comprend une phase de mesure de la tension aux bornes de la cellule sous le courant de référence i_{ref} à plusieurs instants d'une phase de charge ou de décharge de la cellule entre des premier et second niveaux de charge de la cellule. Les premier et second niveaux de charge sont tels que la plage allant du premier au second niveau de charge comprenne le niveau de charge Q_{A} du point A de la cellule. A titre d'exemple, les mesures de tension sont effectuées sur une plage de niveaux de charge allant de 20% à 60% de la capacité nominale de la cellule, ou sur une plage de niveaux d'état de charge (SOC) allant de 20% à 80%.

La phase de charge ou de décharge du procédé de détermination du SOH peut correspondre à une charge ou une décharge de la cellule par utilisation normale de la batterie par un système comportant la batterie. Si le courant de charge ou de décharge normal de la cellule est différent du courant de référence i_{ref}, le dispositif de gestion peut périodiquement forcer le courant traversant la cellule à la valeur i_{ref} pendant une durée de préférence suffisamment courte pour ne pas gêner l'utilisateur, par exemple pendant une durée inférieure à 1 ms et de préférence inférieure à 10 µs, le temps d'effectuer une mesure de la tension aux bornes de la cellule. Cette durée est de préférence choisie, le cas échéant, identique ou similaire, par exemple égale à 20% près, à la durée pendant laquelle le courant est périodiquement forcé à la valeur i_{ref} pendant la phase de caractérisation. A titre de variante, le procédé de détermination du SOH peut comprendre une phase dédiée de charge ou de décharge de la cellule, qui peut être mise en oeuvre par le dispositif de gestion de la batterie spécifiquement pour déterminer le SOH de la cellule.

Dans cet exemple, pendant le procédé de détermination du SOH, le dispositif de gestion mesure la charge accumulée dans la cellule ou extraite de la cellule entre les différentes mesures de tension, par exemple au moyen d'un compteur de coulombs ou d'un intégrateur de courant. On notera que si le régime de charge ou de décharge de la cellule pendant le procédé de détermination du SOH est considéré stable et connu, la variation de charge dans la cellule entre deux mesures de tension est proportionnelle au temps écoulé entre les deux mesures. Le circuit de gestion peut alors estimer les variations de charge par la simple connaissance du temps écoulé entre les mesures de tension, qui peut par exemple être mesuré au moyen d'une horloge. Un avantage est que le SOH de la cellule peut alors être déterminé sans mesure de courant.

Les valeurs de tension mesurées sous le courant i_{ref}, ainsi que les variations de charge de la cellule entre les différentes mesures de tension, peuvent être mémorisées, par exemple dans une mémoire du dispositif de gestion.

Le procédé de détermination du SOH de la cellule comprend en outre une étape de détection du passage de la tension aux bornes de la cellule sous le courant de référence i_{ref}, par la valeur particulière de tension U_{A} du point A.

Selon un premier exemple de réalisation, une fois que le passage de la cellule par la tension U_{A} a été détecté, le SOH peut être estimé par le dispositif de gestion de la batterie en calculant une grandeur représentative de la pente, au point de tension U_{A}, de la courbe caractéristique de la tension sous le courant i_{ref} en fonction des variations de charge de la cellule. A titre d'exemple, cette grandeur peut être le coefficient directeur de l'interpolation linéaire de la caractéristique au point de tension U_{A}, le coefficient directeur de la dérivée de la caractéristique au point de tension U_{A}, l'angle du vecteur directeur de l'interpolation linéaire de la caractéristique au point de tension U_{A}, etc.

Les inventeurs ont en effet constaté (comme cela apparaît sur la figure 1) que la pente, au point de tension U_{A}, de la courbe représentative de la tension de la cellule sous le courant i_{ref} en fonction de la variation de charge de la cellule, varie de façon sensiblement monotone avec le SOH de la cellule. En particulier, dans le cas de cellules lithium-ion, les inventeurs ont constaté que la pente, au point de tension U_{A}, de la courbe représentative de la tension de la cellule sous le courant i_{ref} en fonction de la variation de charge de la cellule, varie de façon sensiblement linéaire avec le SOH de la cellule.

Ce phénomène de linéarité est illustré par la figure 2 représentant l'évolution du coefficient directeur, en mV/% (en ordonnée), au point de tension UA, de la courbe représentative de la tension de la cellule sous le courant i_{ref} en fonction de la variation de charge de la cellule, en fonction du SOH de la cellule, en % (en abscisse).

Pour un type de cellule donné, une phase de caractérisation peut être mise en oeuvre, permettant de déterminer une loi de variation du SOH de la cellule en fonction de la pente, au point de tension U_{A}, de la courbe représentative de la tension de la cellule sous le courant i_{ref} en fonction de la variation de charge de la cellule. Pour cela, on peut mesurer cette pente caractéristique pour plusieurs SOH distincts d'une même cellule que l'on vieillit volontairement en laboratoire pour les besoins de la caractérisation. A titre d'exemple, cette caractérisation peut être effectuée en même temps qu'une phase de caractérisation effectuée pour déterminer la position du point A pour les cellules du type considéré.

Le dispositif de gestion de la batterie peut comporter un circuit de conversion permettant de fournir une estimation du SOH de la cellule en fonction de la grandeur représentative de la pente, au point de tension U_{A}, de la courbe caractéristique de la tension de la cellule sous le courant i_{ref} en fonction des variations de charge de la cellule. A titre d'exemple non limitatif, le circuit de conversion peut comporter une table de correspondance comportant des valeurs de pente caractéristique déterminées pour des SOH distincts lors de la caractérisation, et des moyens de calcul permettant d'interpoler le SOH pour les valeurs de pente non comprises dans la table de correspondance. A titre de variante, si une expression analytique approximant la loi de variation de la pente caractéristique en fonction du SOH des cellules a été déterminée lors de la caractérisation, cette expression peut être utilisée par le circuit de conversion pour estimer le SOH de la cellule.

Selon un deuxième exemple de réalisation, une fois que le passage de la cellule par la tension U_{A} a été détecté, le SOH peut être estimé par le dispositif de gestion de la batterie en calculant une grandeur représentative de la moyenne des valeurs mesurées de tension de la cellule sous le courant i_{ref} (de préférence sur un nombre de points relativement important pour s'affranchir d'éventuelles variations parasites des valeurs mesurées), dans une plage de niveaux de charge de la cellule excluant le point A, et de préférence dans une plage de niveaux de charge supérieure au point A, par exemple dans la plage allant du niveau Q_{A}+10% de la capacité nominale de la cellule au niveau Q_{A}+20% de la capacité nominale de la cellule (c'est-à-dire dans la plage allant de 50% à 60% de la capacité nominale de la cellule dans l'exemple de la figure 1).

Les inventeurs ont en effet constaté que la moyenne, dans une plage de niveaux de charge excluant le point A, de la tension aux bornes de la cellule sous le courant i_{ref}, varie de façon sensiblement monotone avec le SOH de la cellule. En particulier, dans une plage de niveaux de charge supérieure au point A, la moyenne de la tension aux bornes de la cellule sous le courant i_{ref} est d'autant plus élevée que le SOH de la cellule est faible (c'est-à-dire que le vieillissement de la cellule est important).

Pour un type de cellule donné, une phase de caractérisation peut être mise en oeuvre, permettant de déterminer une loi de variation du SOH d'une cellule en fonction de la moyenne de la tension de la cellule sous le courant i_{ref}, dans une plage de niveaux de charge que l'on choisit et qui ne comprend pas le niveau Q_{A}. Pour cela, on peut mesurer cette moyenne caractéristique pour plusieurs SOH distincts d'une même cellule que l'on vieillit volontairement en laboratoire pour les besoins de la caractérisation. A titre d'exemple, cette caractérisation peut être effectuée en même temps qu'une phase de caractérisation effectuée pour déterminer la position du point A pour les cellules du type considéré.

Le dispositif de gestion de la batterie peut comporter un circuit de conversion permettant de fournir une estimation du SOH de la cellule en fonction de la moyenne de la tension de la cellule sous le courant i_{ref}, dans la plage de niveaux de charge de référence choisie. A titre d'exemple non limitatif, le circuit de conversion peut comporter une table de correspondance comportant des valeurs caractéristiques de tension moyenne dans la plage de niveaux de charge de référence, et des moyens de calcul permettant d'interpoler le SOH pour les valeurs de tension moyenne non comprises dans la table de correspondance. A titre de variante, si une expression analytique approximant la loi de variation du SOH des cellules en fonction de la tension moyenne de la cellule sous le courant i_{ref} dans la plage de référence choisie, a été déterminée lors de la caractérisation, cette expression peut être utilisée par le circuit de conversion pour estimer le SOH de la cellule.

Selon un troisième exemple de réalisation, une fois que le passage de la cellule par la tension U_{A} a été détecté, la cellule peut être entièrement chargée. Pendant cette phase de charge, la quantité de charge Q1 accumulée dans la cellule peut être mesurée, par exemple au moyen d'un compteur coulométrique ou estimée, par exemple au moyen d'une mesure temporelle si le régime de charge est connu. Lorsque la pleine charge de la cellule est atteinte, la capacité totale de la cellule Q_{Ti} peut être calculée par la formule Q_{Ti} = Q_{A} + Q1, ce qui permet de calculer le SOH de la cellule.

En pratique, pour que la mesure du SOH soit transparente pour l'utilisateur dans le cas où un passage de la cellule par la tension U_{A} est détecté pendant une phase de décharge de la cellule, on peut prévoir, une fois que le passage de la cellule par la tension U_{A} a été détecté, de laisser l'utilisateur continuer à décharger la cellule en mesurant ou en estimant la quantité de charge Q2 débitée à partir du passage au point A. Une fois que l'utilisateur a terminé d'utiliser la batterie, on peut prévoir de recharger entièrement la batterie. Pendant cette phase de recharge, la quantité de charge Q3 accumulée dans la cellule peut être mesurée ou estimée. Lorsque la pleine charge de la cellule est atteinte, la capacité totale de la cellule Q_{Ti} peut être calculée par la formule Q_{Ti} = Q_{A} - Q2 + Q3, ce qui permet de calculer le SOH de la cellule.

Un avantage de ce troisième exemple de réalisation est qu'il permet de déterminer le SOH d'une cellule sans avoir à décharger entièrement cette cellule, et sans faire appel à des tables embarquées de courbes et/ou valeurs caractéristiques.

Un avantage des procédés de détermination du SOH d'une cellule du type décrit dans la présente demande est que le SOH peut être déterminé sans charge ou décharge complète de la cellule. Ceci permet de rendre la détermination du SOH moins contraignante qu'avec les solutions connues. On peut notamment prévoir des phases de détermination du SOH plus fréquentes que dans les systèmes existants, ce qui permet par exemple d'augmenter la fiabilité des jauges d'état de charge des cellules.

Les modes de réalisation décrits dans la présente demande de procédé de détection du passage au point A d'une cellule, ou de recalage d'une jauge d'état de charge d'une cellule, ou de détermination du SOH d'une cellule, bien que ne se limitant pas à ce cas particulier, présentent un intérêt tout particulier pour une utilisation dans une batterie à architecture électrique reconfigurable dynamiquement. Par batterie à architecture électrique reconfigurable dynamiquement, on entend ici une batterie dans laquelle le schéma d'interconnexion des cellules élémentaires de la batterie entre les bornes de fourniture de tension de la batterie peut être modifié dynamiquement pendant le fonctionnement de la batterie, de façon que la batterie fournisse à ses bornes une tension alternative, par exemple destinée à l'alimentation d'un moteur électrique ou de toute autre charge susceptible d'être alimentée par une tension alternative. Des exemples de réalisation de batteries à architecture électrique reconfigurable dynamiquement sont par exemple décrits dans les demandes de brevet FR2972304, FR2972305, FR2972306 et FR2972308 de la demanderesse.

Une batterie à architecture électrique reconfigurable dynamiquement comprend typiquement un dispositif de gestion capable de déconnecter et reconnecter dynamiquement des cellules de la batterie, éventuellement en modifiant leur position et/ou leur mode de connexion (série ou parallèle) par rapport aux autres cellules de la batterie, à une fréquence relativement élevée, pendant des phases d'utilisation de la batterie.

A chaque déconnexion d'une cellule, le courant traversant cette cellule s'annule pendant la période de déconnexion, par exemple comprise dans la plage allant de 1 µs à 1 ms. Avantageusement, le dispositif de gestion de la batterie peut exploiter ces fréquentes déconnexions pour mettre en oeuvre un procédé du type susmentionné pour un courant de référence i_{ref} nul. Pour cela, le système de gestion peut mesurer la tension de la cellule pendant des périodes de déconnexion de la cellule faisant partie du fonctionnement normal du système, par exemple en vue de détecter un passage de la cellule par la tension U_{A} du point A, et/ou pour déterminer le SOH de la cellule par les méthodes décrites ci-dessus. Un avantage est que les mesures de tension sous le courant i_{ref} ne nécessitent alors aucune perturbation du régime de fonctionnement normal de la batterie.

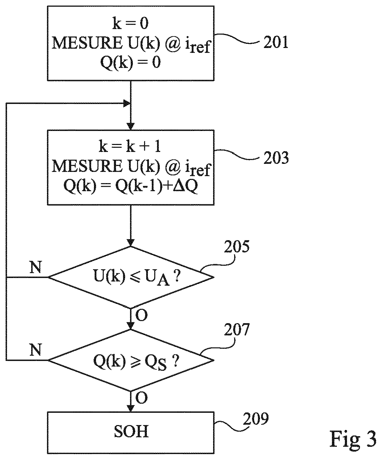

La figure 3 illustre, sous forme de blocs, un exemple non limitatif d'un mode de réalisation d'un procédé de détermination du SOH d'une cellule d'une batterie, qui peut être mis en oeuvre pendant une phase de décharge de la cellule. On notera qu'à partir de la description qui suit, l'homme du métier saura adapter le procédé de la figure 3 pour déterminer le SOH pendant une phase de charge de la cellule.

Le procédé de la figure 3 peut être déclenché par le dispositif de gestion de la batterie pendant une phase de décharge de la cellule, avant que le niveau de charge de la cellule n'atteigne la valeur Q_{A}. A titre d'exemple non-limitatif, le procédé de la figure 3 est déclenché lorsque l'état de charge de la cellule atteint un seuil compris dans la plage allant de 60% à 80% du SOC.

Le procédé de la figure 3 comprend une étape initiale 201 au cours de laquelle la tension aux bornes de la cellule est mesurée sous le courant i_{ref}, et la valeur de tension mesurée est écrite dans un champ U(0), de rang k = 0, d'une table U de mémorisation des valeurs de tension mesurées. Lors de l'étape 201, un champ Q(0), de rang k = 0, d'une table Q de mémorisation de valeurs de quantité de charge extraite de la cellule, est initialisée à la valeur 0.

Lors d'une étape 203 postérieure à l'étape 201, l'indice k de pointage dans les tables U et Q est incrémenté de 1, et la tension aux bornes de la cellule est à nouveau mesurée sous le courant i_{ref}. La valeur de tension mesurée est écrite dans le champ U(k) de la table U. De plus, lors de l'étape 203, la variation de charge ΔQ de la cellule entre l'étape de mesure de la tension U(k-1) et l'étape de mesure de la tension U(k) est déterminée, par exemple par comptage coulométrique, ou estimée à partir du temps écoulé entre les deux mesures. La valeur Q(k-1)+ΔQ est écrite dans le champ Q(k) de la table Q.

Lors d'une étape 205, le dispositif de gestion vérifie si la tension U(k) mesurée à l'étape 203 a franchi la valeur de tension U_{A} du point caractéristique A de la cellule. Si, lors de l'étape 205, la valeur U (k) est supérieure à la valeur U_{A}, les étapes 203 et 205 sont réitérées.

Si, lors de l'étape 205, la valeur U(k) est inférieure ou égale à la valeur U_{A}, une étape 207 est mise en oeuvre au cours de laquelle le dispositif de gestion vérifie si la variation de charge Q(k) de la cellule depuis le début du procédé a atteint un seuil Q_{S}. Si, lors de l'étape 205, la valeur Q(k) est inférieure au seuil Q_{S}, les étapes 203, 205 et 207 sont réitérées. Si, lors de l'étape 207, la valeur Q(k) est supérieure ou égale à la valeur Q_{S}, une étape 209 de détermination du SOH de la cellule est mise en oeuvre.

Lors de l'étape 209, le SOH peut par exemple être déterminé à partir des valeurs contenues dans les tables U et Q, selon l'une des méthodes susmentionnées, à savoir par calcul d'une grandeur représentative de la pente, au point de tension U_{A}, de la courbe caractéristique de la tension de la cellule sous le courant i_{ref} en fonction des variations de charge de la cellule, ou par calcul d'une grandeur représentative de la moyenne de la tension de la cellule sous le courant i_{ref} dans une plage de niveaux de charge de la cellule supérieurs au point A ou inférieurs au point A. A la fin de l'étape 209, le procédé de détermination du SOH se termine.

Des modes de réalisation particuliers ont été décrits. Diverses variantes et modifications apparaîtront à l'homme de l'art.

En particulier, le dispositif de gestion de la batterie peut optionnellement mémoriser, en plus des coordonnées du point A, l'intégralité d'une ou plusieurs des courbes caractéristiques tension/charge des cellules à un courant de référence i_{ref}, déterminées lors d'une phase de caractérisation des cellules. Dans ce cas, pour évaluer l'état de charge d'une cellule de la batterie, le dispositif de gestion peut effectuer une mesure de la tension aux bornes de la cellule sous le courant i_{ref}, et estimer l'état de charge de la cellule à partir de cette mesure et des courbes caractéristiques mémorisées. La courbe particulière utilisée pour effectuer une estimation d'état de charge d'une cellule peut être sélectionnée en tenant compte du SOH de la cellule.

En outre, lors de la phase de caractérisation des cellules, les coordonnées du point A, ainsi que les pentes caractéristiques des courbes tension/charge au point A, et/ou les moyennes caractéristiques de la tension dans une plage de niveaux de charge excluant le point A, peuvent optionnellement être déterminées pour plusieurs courants de référence i_{ref} distincts. Dans ce cas, lorsque le dispositif de gestion met en oeuvre une phase de détermination du SOH par un procédé du type susmentionné, il peut choisir le courant de référence le mieux adapté à l'utilisation qui est faite de la batterie pendant la phase de détermination du SOH.

## Revendications

1. Procédé de détermination de l'état de santé d'une première cellule élémentaire d'une batterie, comprenant les étapes suivantes :
mesurer la tension (U(k)) aux bornes de la cellule sous un courant de référence (i_{ref}) à plusieurs instants d'une phase de charge ou de décharge de la cellule entre des premier et second niveaux d'état de charge ; et
détecter un passage de ladite tension (U(k)) par une valeur particulière prédéterminée (U_{A}), correspondant à une valeur particulière prédéterminée (Q_{A}) de charge de la cellule, lesdites valeurs particulières de charge (Q_{A}) et de tension (U_{A}) correspondant aux coordonnées d'un point (A) de croisement d'au moins deux courbes (101a, 101b, 101c) représentatives de l'évolution de ladite tension (U(k)) en fonction de la charge contenue dans la cellule, à des états de vieillissement distincts de la cellule.

2. Procédé selon la revendication 1, comportant en outre la détermination et la mémorisation de variations de charge (ΔQ) de la cellule entre lesdites mesures de tension.

3. Procédé selon la revendication 2, dans lequel lesdites variations de charge (ΔQ, Q(k)) sont mesurées par un compteur de coulombs ou un intégrateur de courant.

4. Procédé selon la revendication 2, dans lequel lesdites variations de charge (ΔQ, Q(k)) sont estimées en tenant compte du temps écoulé entre lesdites mesures de tension.

5. Procédé selon l'une quelconque des revendications 2 à 4, comportant une étape de détermination de la pente de la courbe représentative de l'évolution de ladite tension (U(k)) en fonction de la variation de charge (ΔQ, Q(k)) de la cellule, au passage par ladite valeur particulière (U_{A}) de tension.

6. Procédé selon l'une quelconque des revendications 2 à 4, comportant une étape de calcul de la valeur moyenne de ladite tension (U(k)) entre des premier et second niveaux de charge de la cellule, lesdits premier et second niveaux de charge étant tous deux supérieurs à ladite valeur particulière de charge (Q_{A}) ou tous deux inférieurs à ladite valeur particulière de charge (Q_{A}).

7. Procédé selon l'une quelconque des revendications 1 à 6 comprenant en outre, après la détection du passage de ladite tension (U(k)) par ladite valeur particulière prédéterminée (U_{A}), une étape de recharge complète de la cellule, et la mesure de la charge injectée dans la cellule pendant cette étape de recharge.

8. Procédé selon l'une quelconque des revendications 1 à 7, dans lequel ladite valeur particulière de charge (Q_{A}) est comprise entre 20% et 60% de la capacité nominale de pleine charge de la cellule.

9. Procédé selon l'une quelconque des revendications 1 à 8, dans lequel ladite cellule est une cellule de type lithium-ion, et dans lequel ladite valeur particulière de charge (Q_{A}) est comprise entre 38% et 42% de la capacité nominale de pleine charge de la cellule.

10. Procédé selon la revendication 9, dans lequel ladite cellule présente une capacité nominale de 2,2 Ah et une tension nominale de pleine charge de 4,2 V, et dans lequel ladite valeur particulière de tension (Q_{A}) est comprise dans la plage allant de 3,5 V à 3,6 V.

11. Procédé selon l'une quelconque des revendications 1 à 10, comportant en outre une phase préalable de caractérisation comportant l'acquisition, pour une deuxième cellule élémentaire de même type que la première cellule, d'au moins deux courbes caractéristiques (101a, 101b, 101c) représentatives de l'évolution de la tension aux bornes de la deuxième cellule en fonction de la charge contenue dans la deuxième cellule, à au moins deux états de vieillissement distincts de la deuxième cellule.

12. Procédé selon la revendication 11, dans lequel la phase préalable de caractérisation comprend en outre une étape de détermination d'un point (A) de croisement desdites au moins deux courbes caractéristiques dans la plage de charge allant de 20% à 60% de la capacité nominale de la cellule.

13. Système comportant :
une batterie comportant plusieurs cellules élémentaires ; et
un dispositif de gestion de la batterie,
dans lequel le dispositif de gestion est adapté à déterminer l'état de santé d'une cellule élémentaire par un procédé selon l'une quelconque des revendications 1 à 12.

14. Système selon la revendication 13, dans lequel la batterie est une batterie à architecture reconfigurable dynamiquement, et dans lequel le dispositif de gestion est adapté à déconnecter et reconnecter dynamiquement des cellules de la batterie de façon que la batterie fournisse à ses bornes une tension alternative.

15. Système selon la revendication 14, dans lequel ledit courant de référence (i_{ref}) est nul, et dans lequel lesdites étapes de mesure de la tension (U(k)) aux bornes de la première cellule sont mises en oeuvre pendant des périodes de déconnexion de la première cellule par le dispositif de gestion en vue de la génération d'une tension alternative aux bornes de la batterie.

## Patentansprüche

1. Ein Verfahren zum Bestimmen des Zustandes bzw. der Verfassung einer ersten Elementarzelle einer Batterie bzw. eines Akkus, das die folgenden Schritte aufweist:
Messen der Spannung (U(k)) über die Zelle hinweg unter einem Referenzstrom (i_{ref}) zu einer Vielzahl von Zeiten in einer Phase einer Zellenladung oder -entladung zwischen ersten und zweiten Ladezustandspegeln; und
Detektieren des Schneidens bzw. Übertretens, durch die Spannung (U(k)), eines vorbestimmten, spezifischen Wertes (U_{A}), der einem vorbestimmten, spezifischen Ladungswert (Q_{A}) der Zelle entspricht, wobei die spezifischen Ladungswerte (Q_{A}) und Spannungswerte (U_{A}) den Koordinaten eines Schnittpunktes (A) von wenigstens zwei Kurven (101 a, 101 b, 101 c) entsprechen, die für die Variation der Spannung (U(k)) gemäß der Ladung, die in der Zelle enthalten ist, repräsentativ sind, und zwar für unterschiedliche Verfassungen der Zelle.

2. Verfahren nach Anspruch 1, das weiter Bestimmen und Speichern von Variationen der Zellenladung (ΔQ) zwischen den Spannungsmessungen aufweist.

3. Verfahren nach Anspruch 2, wobei die Ladungsvariationen (ΔQ, Q(k)) durch ein Coulometer oder einen Stromintegrierer gemessen werden.

4. Verfahren nach Anspruch 2, wobei die Ladungsvariationen (ΔQ, Q(k)) geschätzt werden, indem die Zeit berücksichtigt wird, die zwischen Spannungsmessungen verstrichen ist.

5. Verfahren nach einem der Ansprüche 2 bis 4, das einen Schritt des Bestimmens der Steigung der Kurve aufweist, die für die Variation der Spannung (U(k)) gemäß der Ladungsvariation (ΔQ, Q(k)) der Zelle repräsentativ ist, und zwar an dem Schnittpunkt bzw. beim Übertreten des spezifischen Spannungswertes (U_{A}).

6. Verfahren nach einem der Ansprüche 2 bis 4, das einen Schritt des Berechnens des durchschnittlichen Wertes der Spannung (U(k)) zwischen ersten und zweiten Zellenladungspegeln aufweist, wobei die ersten und zweiten Ladungspegel beide höher sind als der spezifische Ladungswert (Q_{A}) oder beide niedriger sind als der spezifische Ladungswert (Q_{A}).

7. Verfahren nach einem der Ansprüche 1 bis 6, das weiter, nach dem Detektieren des Schneidens bzw. Übertretens, durch die Spannung (U(k)), des vorbestimmen spezifischen Wertes (U_{A}), einen Schritt einer vollen Wiederaufladung der Zelle und die Messung der Ladung, die in die Zelle während dieses Wiederaufladungsschrittes eingespeist wird, aufweist.

8. Verfahren nach einem der Ansprüche 1 bis 7, wobei der spezifische Ladungswert (Q_{A}) in dem Bereich von 20% bis 60% der nominalen vollen Ladungskapazität der Zelle ist.

9. Verfahren nach einem der Ansprüche 1 bis 8, wobei die Zelle eine Zelle vom Lithium-Ionen-Typ ist und wobei der spezifische Ladungswert (Q_{A}) in dem Bereich von 38% bis 42% der nominalen, vollen Ladungskapazität der Zelle ist.

10. Verfahren nach Anspruch 9, wobei die Zelle eine Nennkapazität von 2,2Ah und eine Nennspannung 4,2V bei voller Ladung hat, und wobei der spezifische Spannungswert (Q_{A}) in dem Bereich von 3,5 V bis 3,6 V ist.

11. Verfahren nach einem der Ansprüche 1 bis 10, das weiter eine vorherige Charakterisierungsphase aufweist, die Erfassen, für eine zweite Elementarzelle desselben Typs wie die erste Zelle, von wenigstens zwei charakteristischen Kurven (101 a, 101b, 101c) aufweist, die für die Variation der Spannung über die zweite Zelle hinweg gemäß der Ladung, die in der zweiten Zelle enthalten ist, repräsentativ ist, für wenigstens zwei unterschiedliche Zustände bzw. Verfassungen der zweite Zelle.

12. Verfahren nach Anspruch 11, wobei die vorherige Charakterisierungsphase weiter einen Schritt des Bestimmens eines Schnittpunktes (A) der wenigstens zwei charakteristischen Kurven in dem Ladungsbereich von 20% bis 60% der nominalen Kapazität der Zelle aufweist.

13. Ein System, das Folgendes aufweist:
eine Batterie bzw. einen Akku, der eine Vielzahl von Elementarzellen aufweist; und
eine Batteriemanagementeinrichtung,
wobei die Managementeinrichtung in der Lage ist, den Zustand bzw. die Verfassung einer Elementarzelle durch das Verfahren eines der Ansprüche 1 bis 12 zu bestimmen.

14. System nach Anspruch 13, wobei die Batterie bzw. der Akku eine Batterie bzw. ein Akku mit einer dynamisch rekonfigurierbaren Architektur ist, und wobei die Managementeinrichtung in der Lage ist, dynamisch Zellen der Batterie bzw. des Akkus zu trennen und wieder zu verbinden, so dass eine AC- bzw. Wechselstromspannung über die Batterie hinweg vorgesehen wird.

15. System nach Anspruch 14, wobei der Referenzstrom (i_{ref}) Null ist und wobei die Schritte des Messens der Spannung (U(k)) über die erste Zelle hinweg während Perioden der Trennung der ersten Zelle durch die Managementeinrichtung zur Generierung einer AC-Spannung über die Batterie hinweg implementiert werden.

## Claims

1. A method of determining the state of health of a first elementary cell of a battery, comprising the steps of:
measuring the voltage (U(k)) across the cell under a reference current (i_{ref}) at a plurality of times in a phase of cell charge or discharge between first and second state-of-charge levels; and
detecting a crossing by said voltage (U(k)) of a predetermined specific value (U_{A}), corresponding to a predetermined specific charge value (Q_{A}) of the cell, said specific charge (Q_{A}) and voltage (U_{A}) values corresponding to the coordinates of a crossing point (A) of at least two curves (101a, 101b, 101c) representative of the variation of said voltage (U(k)) according to the charge contained in the cell, for different states of health of the cell.

2. The method of claim 1, further comprising determining and storing variations of the cell charge (ΔQ) between said voltage measurements.

3. The method of claim 2, wherein said charge variations (ΔQ, Q(k)) are measured by a coulometer or a current integrator.

4. The method of claim 2, wherein said charge variations (ΔQ, Q(k)) are estimated by taking into account the time elapsed between said voltage measurements.

5. The method of any of claims 2 to 4, comprising a step of determining the slope of the curve representative of the variation of said voltage (U(k)) according to the charge variation (ΔQ, Q(k)) of the cell, at the crossing of said specific voltage value (U_{A}).

6. The method of any of claims 2 to 4, comprising a step of calculating the average value of said voltage (U(k)) between first and second cell charge levels, said first and second charge levels being both higher than said specific charge value (Q_{A}) or both lower than said specific charge value (Q_{A}).

7. The method of any of claims 1 to 6, further comprising, after the detection of the crossing by said voltage (U(k)) of said predetermined specific value (U_{A}), a step of full recharge of the cell, and the measurement of the charge injected into the cell during this recharge step.

8. The method of any of claims 1 to 7, wherein said specific charge value (Q_{A}) is in the range from 20% to 60% of the nominal full charge capacity of the cell.

9. The method of any of claims 1 to 8, wherein said cell is a cell of lithium-ion type and wherein said specific charge value (Q_{A}) is in the range from 38% to 42% of the nominal full charge capacity of the cell.

10. The method of claim 9, wherein said cell has a 2.2-Ah nominal capacity and a 4.2-V nominal full charge voltage, and wherein said specific voltage value (Q_{A}) is in the range from 3.5 V to 3.6 V.

11. The method of any of claims 1 to 10, further comprising a previous characterization phase comprising acquiring, for a second elementary cell of the same type as the first cell, at least two characteristic curves (101a, 101b, 101c) representative of the variation of the voltage across the second cell according to the charge contained in the second cell, for at least two different states of health of the second cell.

12. The method of claim 11, wherein the previous characterization phase further comprises a step of determining a crossing point (A) of said at least two characteristic curves in the charge range from 20% to 60% of the nominal capacity of the cell.

13. A system comprising:
a battery comprising a plurality of elementary cells; and
a battery management device,
wherein the management device is capable of determining the state of health of an elementary cell by the method of any of claims 1 to 12.

14. The system of claim 13, wherein the battery is a battery with a dynamically reconfigurable architecture, and wherein the management device is capable of dynamically disconnecting and connecting back cells of the battery so that an AC voltage is provided across the battery.

15. The system of claim 14, wherein said reference current (i_{ref}) is zero and wherein said steps of measuring the voltage (U(k)) across the first cell are implemented during periods of disconnection of the first cell by the management device for the generation of an AC voltage across the battery.
